(19)

Europäisches
Patentamt
European
Patent Office
Office européen
des brevets

(11)  **EP 4 019 321 B1**

(12)  **EUROPEAN PATENT SPECIFICATION**

(45) Date of publication and mention
of the grant of the patent:
**09.08.2023  Bulletin 2023/32**

(21) Application number: **21207639.2**

(22) Date of filing: **10.11.2021**

(51) International Patent Classification (IPC):
*B60L 58/16* (2019.01)      *B60L 58/12* (2019.01)
*H02J 7/00* (2006.01)       *B60L 53/10* (2019.01)
*B60L 58/14* (2019.01)      *B60L 58/15* (2019.01)
*H01M 10/42* (2006.01)      *H01M 10/44* (2006.01)
*G01R 31/392* (2019.01)     *G01R 31/367* (2019.01)
*H01M 10/48* (2006.01)

(52) Cooperative Patent Classification (CPC):
**B60L 58/16; B60L 53/11; B60L 58/12; B60L 58/14;
B60L 58/15; H01M 10/425; H01M 10/44;
H01M 10/48; H02J 7/0048; H02J 7/005;
H02J 7/00714; H02J 7/007182;** G01R 31/392;
H01M 2010/4271; H01M 2010/4278;        (Cont.)

(54) **BATTERY MANAGING METHOD AND DEVICE, AND VEHICLE**

VERFAHREN UND VORRICHTUNG ZUR BATTERIEVERWALTUNG UND FAHRZEUG

DISPOSITIF ET PROCÉDÉ DE GESTION DE BATTERIE ET VÉHICULE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **25.12.2020  CN 202011567605**

(43) Date of publication of application:
**29.06.2022  Bulletin 2022/26**

(73) Proprietors:
• **Guangzhou Chengxing Zhidong Motors
Technology Co., Ltd.
Guangzhou, Guangdong 510000 (CN)**
• **Guangzhou Xiaopeng Motors Technology Co.,
Ltd.
Tianhe District
Guangzhou
Guangdong (CN)**

(72) Inventors:
• **HUANG, Lanying
Guangzhou (CN)**

• **WANG, Yanle
Guangzhou (CN)**

(74) Representative: **Rowlands, Stuart Michael et al
Maucher Jenkins
Seventh Floor Offices
Artillery House
11-19 Artillery Row
London SW1P 1RT (GB)**

(56) References cited:
**WO-A1-2017/133760        DE-A1-102020 206 592
DE-A1-102020 212 579      DE-A1-102021 100 163
US-A1- 2017 144 563       US-A1- 2019 148 954
US-A1- 2020 114 775       US-A1- 2020 353 839
US-B2- 10 222 428**

EP 4 019 321 B1

(52) Cooperative Patent Classification (CPC): (Cont.)
    H01M 2220/20; Y02E 60/10; Y02T 10/7072;
    Y02T 90/14

## Description

### Field of Invention

The present application relates to the technical field of batteries, and in particular to a method and device for managing a battery, a vehicle and a computer readable storage medium.

### Background

New energy vehicles, especially pure electric vehicles, are primarily powered by traction batteries, the safety of which has become a priority concern of pure electric vehicles and is affected by various factors, among which aging of the batteries is one of the most significant.

So far, battery life is one leading factor for users to evaluate performance of electric vehicles. Given existing technology and materials, it is difficult to research and develop batteries with higher capacity, while the weight, space and other parameters of whole vehicles are constrained. In a fixed space, as the number of batteries is limited, expanding charge/discharge depth of the batteries within a reasonable range becomes one important route to improve the life expectation of the whole vehicle in order to meet the user's requirement for battery life. In addition to the battery life, charging speed is also an important index for users to evaluate performance of electric vehicles. Thus, most vehicle manufacturers may increase charge currents of batteries as much as possible so as to shorten the charging time of the whole vehicles.

Given the above reasons, the batteries are used to their extremes in order to ensure performance of vehicles. The cumulation of service time of the batteries leads to aging of the batteries and gradually increases the aging degree (lithium plating may be aggravated, etc.). If aged batteries still used in the same way as new batteries, the aging batteries may age much faster, which may lead to great safety risks.

US10222428B2 relates to a method for managing an authorized operating range of a battery, the authorized operating range being limited between a minimum level and a maximum level of state of charge of the battery. The method includes estimating a state of health in power of the battery, the state of health in power characterizing capacity of the battery to supply a minimum required power level across an entirety of the operating range; and determining the minimum level of state of charge of the battery in accordance with the estimated state of health in power, the minimum level of state of charge being increased when the state of health in power decreases.

US2017/144563A1 relates to a method for controlling an output of a battery includes measuring a state of charge (SOC) or a resistance of the battery of a vehicle, comparing a deterioration level of the battery with a set deterioration level, and controlling a temperature of the battery, an average output of the battery, and a load mode of the battery when the deterioration level of the battery is larger than the set deterioration level.

US2020/353839A1 relates to a method of controlling charging operations of electric-drive vehicles that includes a vehicle controller detecting if a vehicle is coupled to an electric vehicle supply equipment (EVSE), and determining if the vehicle's current mileage exceeds a calibrated mileage threshold. Responsive to the vehicle being connected to the EVSE and the vehicle's current mileage exceeding the calibrated mileage threshold, the controller determines the current remaining life of the vehicle's traction battery pack and the current time in service of the vehicle. The vehicle controller determines if the current remaining battery life exceeds a predicted remaining battery life corresponding to the current time in service. If so, the vehicle controller enables the traction battery pack to transmit electrical power to the EVSE.

WO2017/133760 relates to a control device for controlling discharging of a rechargeable battery, the control device comprising a rechargeable dummy cell, a first circuit configured to discharge the battery and the dummy cell, and a second circuit configured to measure the open circuit voltage of the dummy cell. The control device is configured to: determine the open circuit voltage of the dummy cell by using the second circuit, and determine the maximum capacity decrement of the battery, which is to be discharged until full discharging, based on the determined open circuit voltage of the dummy cell.

### Summary of Invention

In view of the above problem, the present application provides a method for managing a battery as set out in claim 1, a device for managing a battery as set out in claim 4, a vehicle as set out in claim 6 and a computer readable storage medium as set out in claim 7 that overcome the above problem and at least partially solve the above problem.

The embodiments of the present application include the following advantages:

battery state parameters are acquired and then compared with the plurality of aging parameter thresholds respectively to determine the target aging level of the battery; and the target charge/discharge parameters corresponding to the target aging level are determined according to the pre-stored correlations between the aging levels and the charge/discharge parameters.

According to the present invention, the target charge/discharge parameters are determined according to the target aging level, such that different charge/discharge parameters may be managed in different aging stages of the battery, thereby slowing down an aging speed of the battery, and reducing a safety risk caused by aging. Additionally, the battery state parameters are compared with the plurality of aging parameter thresholds respectively, thereby more accurately and efficiently determining the aging level of the battery.

## Brief Description of Drawings

Fig. 1 is a flow chart of steps of embodiment 1 of a method for managing a battery of the present application;
Fig. 2 is a flow chart of steps of embodiment 2 of a method for managing a battery of the present application;
Fig. 3 is a flow chart of steps of embodiment 3 of a method for managing a battery of the present application;
Fig. 4 is a flow chart of steps of embodiment 4 of a method for managing a battery of the present application;
Figs. 5A and 5B show a flow chart of steps of embodiment 5 of a method for managing a battery of the present application; and
Fig. 6 is a structural block diagram of one embodiment of a device for managing a battery of the present application.

## Detailed Description

To make the objectives, features, and advantages mentioned above of the present application more apparent and easily understood, the present application will be described in detail below with reference to the drawings and particular implementations.

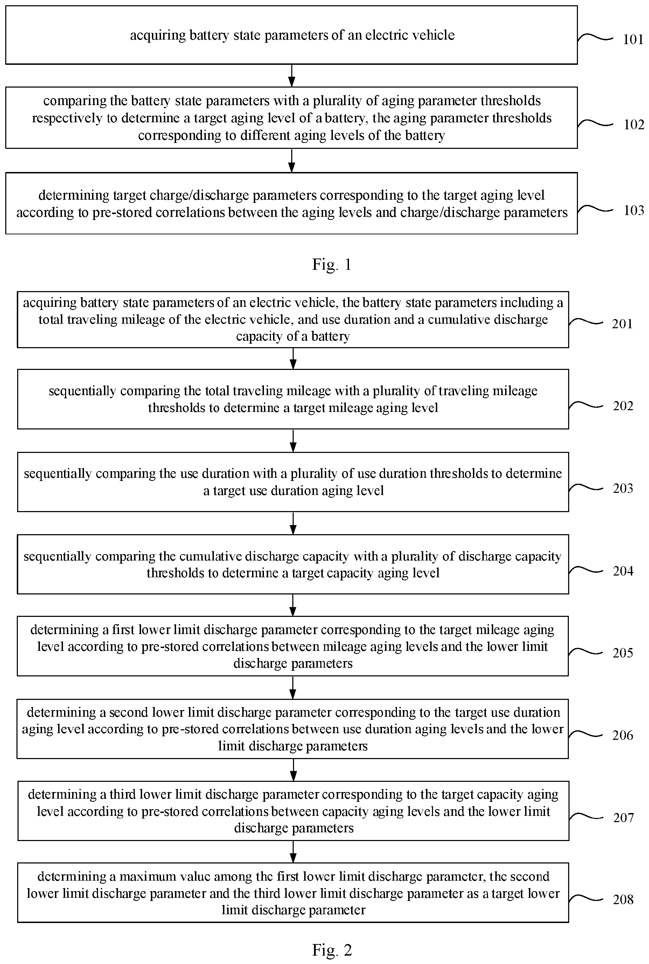

With reference to Fig. 1, a flow chart of steps of embodiment 1 of a method for managing a battery of the present application is shown. The method may specifically include the following steps:

Step 101: acquiring battery state parameters of an electric vehicle.

In the specific implementation, the battery state parameters may be acquired by means of a battery management system (BMS). The battery management system is responsible for controlling charge and discharge of the battery and performing functions of battery state estimation, etc.

The battery state parameters may include, but not limited to, one or more of a total traveling mileage M of the electric vehicle, use duration T and a cumulative discharge capacity $C_d$ of the battery, etc., where the cumulative discharge capacity $C_d$ may be acquired by calculating the integration of discharge current over time. The use duration T of the battery may be acquired by calculating a time difference between a current moment and a delivery moment of the battery.

In the embodiment of the present application, the battery may include, but not limited to, any one of a battery cell, a battery module and a battery pack,
where the battery pack is an energy storage device, and includes a power cell or a power cell module, and generally further includes a battery electronic component, a high voltage protection device, an overcurrent protection device, a battery box and interfaces of other external systems (such as cooling, high-voltage auxiliary low-voltage, communication, etc.).

The battery module is a module formed by connecting power cells on a physical structure and a circuit, and is a minimum group for forming the battery pack or a system.

A battery cell is a minimum unit for forming the battery module, is generally formed by combining a positive electrode, a negative electrode, electrolyte, a diaphragm, a shell, a terminal, etc., and may achieve direct conversion between electric energy and chemical energy.

Step 102: comparing the battery state parameters with a plurality of aging parameter thresholds respectively to determine a target aging level of the battery, the aging parameter thresholds corresponding to different aging levels of the battery.

The plurality of aging parameter thresholds may include, for example, a first aging parameter threshold, a second aging parameter threshold and a third aging parameter threshold, where the first aging parameter threshold<the second aging parameter threshold<the third aging parameter threshold, the first aging parameter threshold corresponds to a first aging level, the second aging parameter threshold corresponds to a second aging level, and the third aging parameter threshold corresponds to a third aging level.

In the specific implementation, the battery state parameters may be compared with the first aging parameter threshold, the second aging parameter threshold, and the third aging parameter threshold respectively, and when the battery state parameters are greater than or equal to the second aging parameter threshold and less than the third aging parameter threshold, it may be determined that the target aging level of the battery is the second aging level.

It should be noted that different battery state parameters may each correspond to one group of aging parameter thresholds, which is to be described in detail in subsequent embodiments.

Step 103: determining target charge/discharge parameters corresponding to the target aging level according to pre-stored correlations between the aging levels and charge/discharge parameters.

The charge/discharge parameters include, but not limited to, at least one of lower limit discharge parameters, upper limit charge parameters, charge rates, etc.

In the specific implementation, the correlations between the aging levels and the charge/discharge parameters may be pre-stored in the battery management system, and after the target charge/discharge parameters are determined, the vehicle may be charged and discharged according to the target charge/discharge parameters. The correlations between the aging levels and the charge/discharge parameters are pre-stored, thereby improving efficiency of determining the target charge/discharge parameters. The subsequent embodiments will show a specific determining process of the target charge/discharge parameters of the battery in detail.

According to the method for managing a battery provided by this embodiment, the target charge/discharge parameters are determined according to the target aging level, such that different charge/discharge parameters may be managed in different aging stages of a whole life cycle of the battery respectively, thereby slowing down an aging speed of the battery to a certain extent, and reducing a safety risk caused by aging; and in addition, the battery state parameters are compared with the plurality of aging parameter thresholds respectively, thereby more accurately and efficiently determining the aging level of the battery.

The plurality of aging parameter thresholds include a plurality of traveling mileage thresholds, a plurality of use duration thresholds and a plurality of discharge capacity thresholds, and the target aging level of the battery may include a target mileage aging level, a target use duration aging level, and a target capacity aging level. With reference to Fig. 2, a flow chart of steps of embodiment 2 of a method for managing a battery of the present application is shown. The method may specifically include the following steps:

Step 201: acquiring battery state parameters of an electric vehicle, the battery state parameters including a total traveling mileage of the electric vehicle, and use duration and a cumulative discharge capacity of the battery.

Step 201 is similar to step 101 and is not repeated herein.

Step 202: sequentially comparing the total traveling mileage with a plurality of traveling mileage thresholds to determine a target mileage aging level.

Step 203: sequentially comparing the use duration with a plurality of use duration thresholds to determine a target use duration aging level.

Step 204: sequentially comparing the cumulative discharge capacity with a plurality of discharge capacity thresholds to determine a target capacity aging level.

Then, a step of determining target charge/discharge parameters corresponding to the target mileage aging level, the target use duration aging level and the target capacity aging level according to pre-stored correlations between the aging levels and charge/discharge parameters may be executed, and when the charge/discharge parameters includes lower limit discharge parameters, the step may specifically include:

Step 205: determining a first lower limit discharge parameter corresponding to the target mileage aging level according to pre-stored correlations between mileage aging levels and the lower limit discharge parameters.

Step 206: determining a second lower limit discharge parameter corresponding to the target **use duration** aging level according to pre-stored correlations between use duration aging levels and the lower limit discharge parameters.

Step 207: determining a third lower limit discharge parameter corresponding to the target capacity aging level according to pre-stored correlations between capacity aging levels and the lower limit discharge parameters.

Step 208: determining a maximum value among the first lower limit discharge parameter, the second lower limit discharge parameter and the third lower limit discharge parameter as a target lower limit discharge parameter.

The lower limit discharge parameters may include, but not limited to, at least one of a lower limit state of charge, a lower limit discharge voltage, etc. The lower limit discharge parameters are a lower limit value of discharge parameters of the battery, that is, the minimum value of various parameters in a discharge process of the battery. For example, the lower limit state of charge is a lower limit value of a state of charge in the discharge process of the battery, and the lower limit discharge voltage is a lower limit value of voltage or a discharge cut-off voltage in the discharge process of the battery. The lower limit discharge parameters may be set to higher values along with aging of the battery, thereby slowing down an aging speed of the battery, and improving a safety coefficient.

In an actual application, the total traveling mileage M, the cumulative discharge capacity $C_d$ and the use duration T are all increased along with use of the battery. This embodiment is described by taking the lower limit state of charge as an example of the lower limit discharge parameters.

In the specific implementation, the total traveling mileage M may be sequentially compared with the plurality of traveling mileage thresholds $M_{SOCDL1}$, $M_{SOCDL2} \cdots \cdots M_{SOCDLn}(M_{SOCDL1} < M_{SOCDL2} < \cdots < M_{SOCDLn})$, and if the total traveling mileage M is greater than or equal to $M_{SOCDLi}$ and less than $M_{SOCDL(i+1)}$, it may be determined that the target mileage aging level is i. If the total traveling mileage M is less than $M_{SOCDL1}$, it may be determined that the target mileage aging level is i = 0.

By the same reasoning, the use duration T may be compared with the plurality of use duration thresholds $T_{SOCDL1}$, $T_{SOCDL2} \cdots \cdots T_{SOCDLn}(T_{SOCDL1} < T_{SOCDL2} <$

$\cdots < T_{SOCDLn}$), and if the use duration T is greater than or equal to $T_{SOCDLk}$ and less than $T_{SOCDL(k+1)}$, it may be determined that the target use duration aging level is k. If the use duration T is less than $T_{SOCDL1}$, it may be determined that the target use duration aging level is k = 0.

By the same reasoning, the cumulative discharge capacity $C_d$ may be sequentially compared with the plurality of discharge capacity thresholds $C_{SOCDL1}$, $C_{SOCDL2} \cdots \cdots C_{SOCDLn}(C_{SOCDL1} < C_{SOCDL2} < \cdots < C_{SOCDLn}$), and if the cumulative discharge capacity $C_d$ is greater than or equal to $C_{SOCDLj}$ and less than $C_{SOCDL(j+1)}$, it may be determined that the target capacity aging level is j. If the cumulative discharge capacity $C_d$ is less than $C_{SOCDL1}$, it may be determined that the target capacity aging level is j = 0.

In the specific implementation, the correlations between the mileage aging levels and the lower limit discharge parameters, the correlations between the use duration aging levels and the lower limit discharge parameters and the correlations between the capacity aging levels and the lower limit discharge parameters may be pre-stored in a battery management system. On the basis of the pre-stored correlations, the first lower limit discharge parameter $SOC_{d1}$ corresponding to the target mileage aging level i, the second lower limit discharge parameter $SOC_{d2}$ corresponding to the target use duration aging level k and the third lower limit discharge parameter $SOC_{d3}$ corresponding to the target capacity aging level j are determined. Then, the maximum value among the first lower limit discharge parameter $SOC_{d1}$, the second lower limit discharge parameter $SOC_{d2}$, and the third lower limit discharge parameter $SOC_{d3}$ may be selected as the target lower limit discharge parameter.

It should be noted that the plurality of traveling mileage thresholds, the plurality of use duration thresholds, the plurality of discharge capacity thresholds, the correlations between the mileage aging levels and the lower limit discharge parameters, the correlations between the use duration aging levels and the lower limit discharge parameters and the correlations between the capacity aging levels and the lower limit discharge parameters may be acquired by means of experimental data statistical analysis, real vehicle data statistical analysis, historical data statistical analysis, etc.

According to the method for managing a battery provided by this embodiment, an aging degree of the battery is comprehensively evaluated from multiple dimensions according to these battery state parameters of the traveling mileage of the whole vehicle, the use duration of the battery and the cumulative discharge capacity of the battery, thereby acquiring a more accurate aging level of the battery. Further, the lower limit discharge parameters are determined according to the aging level of the battery, thereby avoiding excessive discharge in each aging stage of the battery, slowing down the aging speed of the battery, improving safety, and meanwhile, avoiding skipping of a remaining life mileage, and improving user experience.

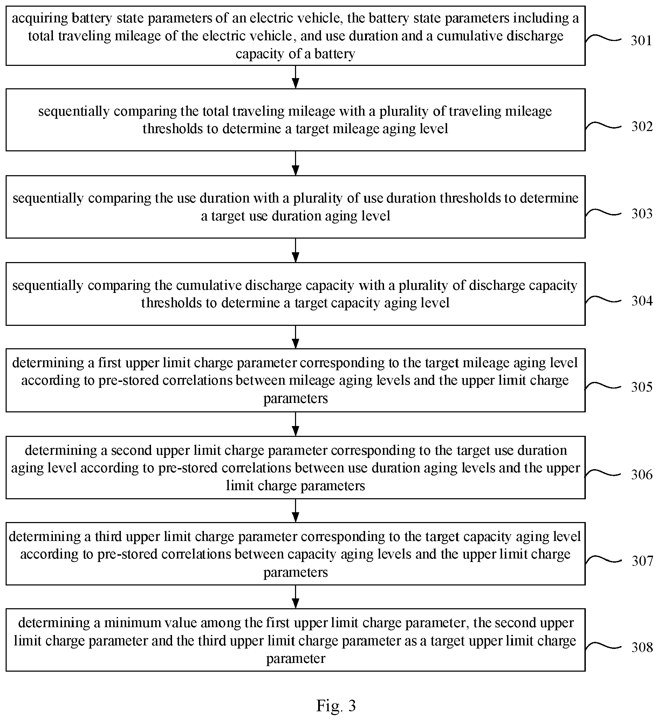

The plurality of aging parameter thresholds includes the plurality of traveling mileage thresholds, the plurality of use duration thresholds, and the plurality of discharge capacity thresholds, and the target aging level of the battery may include the target mileage aging level, the target use duration aging level, and the target capacity aging level. With reference to Fig. 3, a flow chart of steps of embodiment 3 of a method for managing a battery of the present application is shown. The method may specifically include the following steps:

Step 301: acquiring battery state parameters of an electric vehicle, the battery state parameters including a total traveling mileage of the electric vehicle, and use duration and a cumulative discharge capacity of the battery.

Step 301 is similar to step 101 and is not repeated herein.

Step 302: sequentially comparing the total traveling mileage with a plurality of traveling mileage thresholds to determine a target mileage aging level.

Step 303: sequentially comparing the use duration with a plurality of use duration thresholds to determine a target use duration aging level.

Step 304: sequentially comparing the cumulative discharge capacity with a plurality of discharge capacity thresholds to determine a target capacity aging level.

Then, a step of determining target charge/discharge parameters corresponding to the target mileage aging level, the target use duration aging level and the target capacity aging level according to pre-stored correlations between the aging levels and charge/discharge parameters may be executed, and when the charge/discharge parameters include upper limit charge parameters, the step may specifically include:

Step 305: determining a first upper limit charge parameter corresponding to the target mileage aging level according to pre-stored correlations between mileage aging levels and the upper limit charge parameters.

Step 306: determining a second upper limit charge parameter corresponding to the target use duration aging level according to pre-stored correlations between use duration aging levels and the upper limit charge parameters.

Step 307: determining a third upper limit charge parameter corresponding to the target capacity aging level according to pre-stored correlations between capacity aging levels and the upper limit charge parameters.

Step 308: determining a minimum value among the first upper limit charge parameter, the second upper limit charge parameter and the third upper limit charge parameter as a target upper limit charge parameter.

The upper limit charge parameters may include, but not limited to, at least one of an upper limit state of charge, an upper limit charge voltage, etc. The upper limit charge parameters are an upper limit value of charge parameters of the battery, that is, a maximum value of various parameters in a charge process of the battery. For example, the upper limit state of charge is an upper limit value of a state of charge in the charge process, and the upper limit charge voltage is an upper limit value of voltages or a charge cut-off voltage in the charge process of the battery. The upper limit charge parameters may be set to become lower along with aging of the battery, thereby slowing down an aging speed of the battery, and improving a safety coefficient.

When the upper limit charge parameters is the upper limit state of charge, the total traveling mileage M may be sequentially compared with the plurality of traveling mileage thresholds $M_{SOCUL1}$, $M_{SOCUL2}$ ... ... $M_{SOCULn}(M_{SOCUL1} < M_{SOCUL2} < \cdots < M_{SOCULn})$, and if the total traveling mileage M is greater than or equal to $M_{SOCULi}$ and less than $M_{SOCUL(i+1)}$, it may be determined that the target mileage aging level is i. If the total traveling mileage M is less than $M_{SOCUL1}$, it may be determined that the target mileage aging level is i = 0.

By the same reasoning, the use duration T may be compared with the plurality of use duration thresholds $T_{SOCUL1}$, $T_{SOCUL2}$ ... ... $T_{SOCULn}(T_{SOCUL1} < T_{SOCUL2} < \cdots < T_{SOCULn})$, and if the use duration T is greater than or equal to $T_{SOCULk}$ and less than $T_{SOCUL(k+1)}$, it may be determined that the target use duration aging level is k. If the use duration T is less than $T_{SOCUL1}$, it may be determined that the target use duration aging level is k = 0.

By the same reasoning, the cumulative discharge capacity $C_d$ may be sequentially compared with the plurality of discharge capacity thresholds $C_{SOCUL1}$, $C_{SOCUL2}$ ... ... $C_{SOCULn}(C_{SOCUL1} < C_{SOCUL2} < \cdots < C_{SOCULn})$, and if the cumulative discharge capacity $C_d$ is greater than or equal to $C_{SOCULj}$ and less than $C_{SOCUL(j+1)}$, it may be determined that the target capacity aging level is j. If the cumulative discharge capacity $C_d$ is less than $C_{SOCUL1}$, it may be determined that the target capacity aging level is j = 0.

In the specific implementation, the correlations between the mileage aging levels and the upper limit charge parameters, the correlations between the use duration aging levels and the upper limit charge parameters and the correlations between the capacity aging levels and the upper limit charge parameters may be pre-stored in a battery management system. When the upper limit charge parameters are the upper limit state of charge, on the basis of the pre-stored correlations, the first upper limit charge parameter $SOC_{u1}$ corresponding to the target mileage aging level i, the second upper limit charge parameter $SOC_{u2}$ corresponding to the target use duration aging level k and the third upper limit charge parameter $SOC_{u3}$ corresponding to the target capacity aging level j are determined. Then, the minimum value among the first upper limit charge parameter $SOC_{u1}$, the second upper limit charge parameter $SOC_{u2}$, and the third upper limit charge parameter $SOC_{u3}$ may be selected as a target upper limit state of charge.

When the upper limit charge parameters is the upper limit charge voltage, the total traveling mileage M may be sequentially compared with the plurality of traveling mileage thresholds $M_{VUL1}$, $M_{VUL2}$ ... ... $M_{VULn}(M_{VUL1} < M_{VUL2} < \cdots < M_{VULn})$, and if the total traveling mileage M is greater than or equal to $M_{VULi}$ and less than $M_{VUL(i+1)}$, it may be determined that the target mileage aging level is i. If the total traveling mileage M is less than $M_{VUL1}$, it may be determined that the target mileage aging level is i = 0.

By the same reasoning, the use duration T may be compared with the plurality of use duration thresholds $T_{VUL1}$, $T_{VUL2}$ ... ... $T_{VULn}(T_{VUL1} < T_{VUL2} < \cdots < T_{VULn})$, and if the use duration T is greater than or equal to $T_{VULk}$ and less than $T_{VUL(k+1)}$, it may be determined that the target use duration aging level is k. If the use duration T is less than $T_{VUL1}$, it may be determined that the target use duration aging level is k = 0.

By the same reasoning, the cumulative discharge capacity $C_d$ may be sequentially compared with the plurality of discharge capacity thresholds $C_{VUL1}$, $C_{VUL2}$ ... ... $C_{VULn}(C_{VUL1} < C_{VUL2} < \cdots < C_{VULn})$, and if the cumulative discharge capacity $C_d$ is greater than or equal to $C_{VULj}$ and less than $C_{VUL(j+1)}$, it may be determined that the target capacity aging level is j. If the cumulative discharge capacity $C_d$ is less than $C_{VUL1}$, it may be determined that the target capacity aging level is j = 0.

In the specific implementation, the correlations between the mileage aging levels and the upper limit charge parameters, the correlations between the use duration aging levels and the upper limit charge parameters and the correlations between the capacity aging levels and the upper limit charge parameters may be pre-stored in a battery management system. When the upper limit charge parameters are the upper limit charge voltage, on the basis of the pre-stored correlations, the first upper limit charge parameter $V_{u1}$ corresponding to the target mileage aging level i, the second upper limit charge parameter $V_{u2}$ corresponding to the target use duration aging level k and the third upper limit charge parameter $V_{u3}$ corresponding to the target capacity aging level j are determined. Then, the minimum value among the first upper limit charge parameter $V_{u1}$, the second upper limit charge parameter $V_{u2}$, and the third upper limit charge parameter $V_{u3}$ may be selected as the target upper limit charge voltage, that is, a maximum cell voltage protection value allowed for charge may be set to be a target upper limit charge voltage.

In an actual charge process, as long as either the target upper limit state of charge or the target upper limit charge voltage is reached, the battery may be regarded as full.

It should be noted that the plurality of traveling mileage thresholds, the plurality of use duration thresholds, the plurality of discharge capacity thresholds, the correlations between the mileage aging levels and the upper limit charge parameters, the correlations between the use duration aging levels and the upper limit charge parameters and the correlations between the capacity aging levels and the upper limit charge parameters may be acquired by means of experimental data statistical analysis, real vehicle data statistical analysis, historical data statistical analysis, etc.

According to the method for managing a battery provided by this embodiment, an aging degree of the battery is comprehensively evaluated from multiple dimensions according to these battery state parameters of the traveling mileage of the whole vehicle, the use duration of the battery and the cumulative discharge capacity of the battery, thereby acquiring a more accurate aging level of the battery. Further, the upper limit charge parameters are determined according to the aging level of the battery, thereby avoiding excessive charge in each aging stage of the battery, slowing down the aging speed of the battery, improving safety, and meanwhile, avoiding calculation of an inaccurate remaining life mileage, and improving user experience.

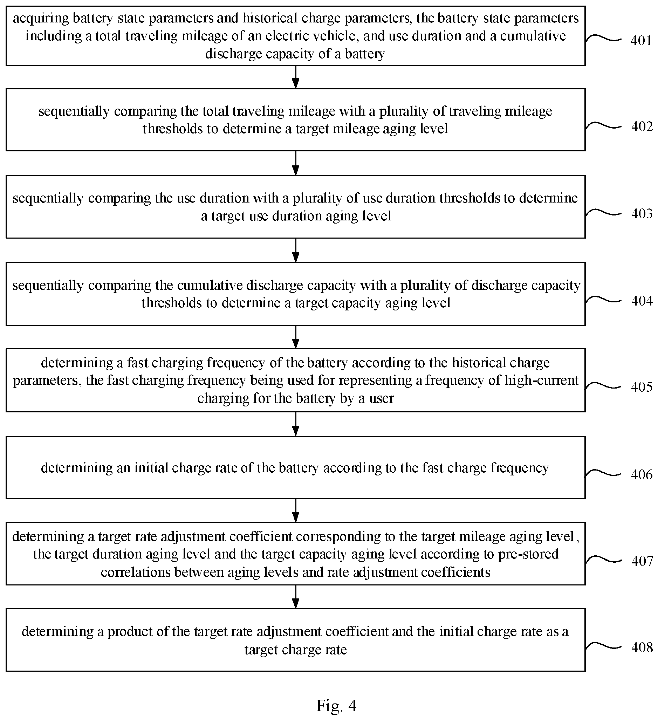

The plurality of aging parameter thresholds include the plurality of traveling mileage thresholds, the plurality of use duration thresholds, and the plurality of discharge capacity thresholds, and the target aging level of the battery may include the target mileage aging level, the target use duration aging level, and the target capacity aging level. With reference to Fig. 4, a flow chart of steps of embodiment 4 of a method for managing a battery of the present application is shown. The method may specifically include the following steps:

Step 401: acquiring battery state parameters and historical charge parameters, the battery state parameters including a total traveling mileage of an electric vehicle, and use duration and a cumulative discharge capacity of the battery.

In the specific implementation, the battery state parameters may be acquired by means of a battery management system (BMS). The battery management system is responsible for controlling charge and discharge of the battery and achieving functions of battery state estimation, etc.

The historical charge parameters may include, but not limited to one or more of a direct current charge cumulative capacity $C_{dchg}$, an alternating current charge cumulative capacity $C_{achg}$, direct current charge times, alternating current charge times, etc. of the battery, where the direct current charge cumulative capacity or the alternating current charge cumulative capacity may be acquired by calculating the integral of charge current over time.

Step 402: sequentially comparing the total traveling mileage with a plurality of traveling mileage thresholds to determine a target mileage aging level.

Step 403: sequentially comparing the use duration with a plurality of use duration thresholds to determine a target use duration aging level.

Step 404: sequentially comparing the cumulative discharge capacity with a plurality of discharge capacity thresholds to determine a target capacity aging level.

Step 405: determining a fast charging frequency of the battery according to the historical charge parameters, the fast charging frequency being used for representing a frequency of high-current charging for the battery by a user.

The historical charge parameters include the direct current charge cumulative capacity and the alternating current charge cumulative capacity of the battery. The step may specifically include calculating a ratio of the direct current charge cumulative capacity to a total charge cumulative capacity, and determining the ratio as the fast charging frequency, the total charge cumulative capacity being the sum of the direct current charge cumulative capacity and the alternating current charge cumulative capacity.

The ratio Y of the direct current charge cumulative capacity $C_{dchg}$ to the total charge cumulative capacity $C_{dchg} + C_{achg}$ determines the fast charging frequency

$$Y = \left. C_{dchg} \middle/ (C_{dchg} + C_{achg}) \right.$$

, $Y \leq 1$, and as Y approaches 1, it is indicative of a higher frequency of using high-current charging by the vehicle.

Step 406: determining an initial charge rate of the battery according to the fast charging frequency.

In the specific implementation, when the fast charging frequency is greater than or equal to a frequency threshold, the initial charge rate of the battery is determined as a first initial charge rate; and when the fast charging frequency is less than the frequency threshold, the initial charge rate of the battery is determined as a second initial charge rate, where the first initial charge rate is less than the second initial charge rate.

Specifically, when the fast charging frequency $Y \geq$ the frequency threshold Yn, a special initial charge rate, i.e., the first initial charge rate, may be used for charge; and if Y<Yn, a common initial charge rate, i.e., the second initial charge rate may be used for charge.

Then, the determining target charge/discharge parameters corresponding to the target mileage aging level, the target use duration aging level and the target capacity aging level according to pre-stored correlations between the aging levels and charge/discharge parameters may be executed, and when the charge/discharge parameters include charge rates, the step may specifically include:

Step 407: determining a target rate adjustment coefficient corresponding to the target mileage aging level, the target use duration aging level and the target capacity aging level according to pre-stored correlations between the aging levels and rate adjustment coefficients.

In the specific implementation, a first rate adjustment coefficient corresponding to the target mileage aging level may be determined according to pre-stored correlations between mileage aging levels and the rate adjustment coefficients; a second rate adjustment coefficient corresponding to the target use duration aging level is determined according to pre-stored correlations between use duration aging levels and the rate adjustment coefficients; a third rate adjustment coefficient corresponding to the target capacity aging level is determined according to pre-stored correlations between capacity aging levels and the rate adjustment coefficients; and a minimum value among the first rate adjustment coefficient, the second rate adjustment coefficient and the third rate adjustment coefficient is determined as the target rate adjustment coefficient.

Step 408: determining a product of the target rate adjustment coefficient and the initial charge rate as a target charge rate.

The target charge rate is a maximum initial charge rate of the battery in a charge process. The rate adjustment coefficient may be set to be smaller and smaller along with aging of the battery, thereby slowing down an aging speed of the battery, and improving a safety coefficient.

In an actual application, the total traveling mileage, the cumulative discharge capacity and the use duration are all increased along with use of the battery.

In the specific implementation, the total traveling mileage M may be sequentially compared with the plurality of traveling mileage thresholds $M_{PL1}$, $M_{PL2}$ ... ... $M_{PLn}$ ($M_{PL1} < M_{PL2} < \cdots < M_{PLn}$), and if the total traveling mileage M is greater than or equal to $M_{PLi}$ and less than $M_{PL(i+1)}$, it may be determined that the target mileage aging level is i. If the total traveling mileage M is less than $M_{PL1}$, it may be determined that the target mileage aging level is i = 0.

By the same reasoning, the use duration T may be compared with the plurality of use duration thresholds $T_{PL1}$, $T_{PL2}$ ... ... $T_{PLn}$($T_{PL1} < T_{PL2} < \cdots < T_{PLn}$), and if the use duration T is greater than or equal to $T_{PLk}$ and less than $T_{PL(k+1)}$, it may be determined that the target use duration aging level is k. If the use duration T is less than $T_{PL1}$, it may be determined that the target use duration aging level is k = 0.

By the same reasoning, the cumulative discharge capacity $C_d$ may be sequentially compared with the plurality of discharge capacity thresholds $C_{PL1}$, $C_{PL2}$ ... ... $C_{PLn}$($C_{PL1} < C_{PL2} < \cdots < C_{PLn}$), and if the cumulative discharge capacity $C_d$ is greater than or equal to $C_{PLj}$ and less than $C_{PL(j+1)}$, it may be determined that the target capacity aging level is j. If the cumulative discharge capacity $C_d$ is less than $C_{PL1}$, it may be determined that the target capacity aging level is j = 0.

In the specific implementation, the correlations between the mileage aging levels and the rate adjustment coefficients, the correlations between the use duration aging levels and the rate adjustment coefficients and the correlations between the capacity aging levels and the rate adjustment coefficients may be pre-stored in the battery management system. On the basis of the pre-stored correlations, the first rate adjustment coefficient $A_{p1}$ corresponding to the target mileage aging level i, the second rate adjustment coefficient $A_{p2}$ corresponding to the target use duration aging level k and the third rate adjustment coefficient $A_{p3}$ corresponding to the target capacity aging level j are determined. Then, the minimum value among the first rate adjustment coefficient $A_{p1}$, the second rate adjustment coefficient $A_{p2}$, and the third rate adjustment coefficient $A_{p3}$ may be selected as the target rate adjustment coefficient.

It should be noted that the plurality of traveling mileage thresholds, the plurality of use duration thresholds, the plurality of discharge capacity thresholds, the correlations between the mileage aging levels and the rate adjustment coefficients, the correlations between the use duration aging levels and the rate adjustment coefficients and the correlations between the capacity aging levels and the rate adjustment coefficients may be acquired by means of experimental data statistical analysis, real vehicle data statistical analysis, historical data statistical analysis, etc. The rate adjustment coefficients corresponding to the mileage aging level 0, the use duration aging level 0 and the capacity aging level 0 respectively may be 1.

According to the method for managing a battery provided by this embodiment, an aging degree of the battery is comprehensively evaluated from multiple dimensions according to these battery state parameters of the traveling mileage of the whole vehicle, the use duration of the battery and the cumulative discharge capacity of the battery, thereby acquiring a more accurate aging level of the battery. Further, the target charge rate is comprehensively determined according to the aging level of the battery and a charge habit of a user, such that it is ensured that each aging stage of the battery may avoid high-current charging, thereby slowing down the aging speed of the battery and improving safety. Determining of the charge/discharge parameters involves comprehensive consideration of the charge habit of the user, i.e., an influence of the fast charging frequency, thereby setting different charge/discharge parameters for different users, and achieving personalized adjustment of the charge/discharge parameters.

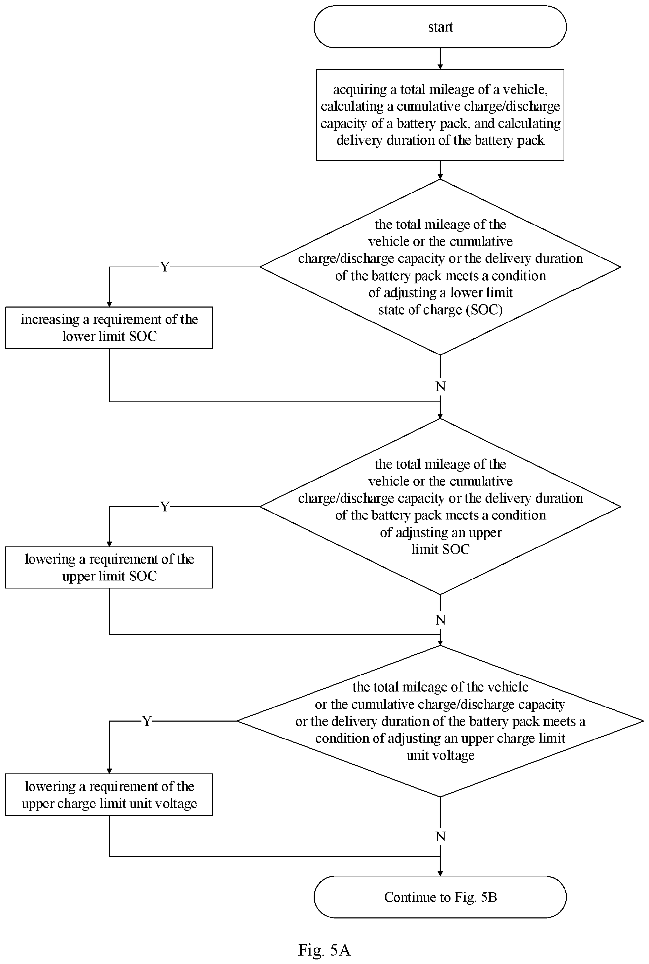

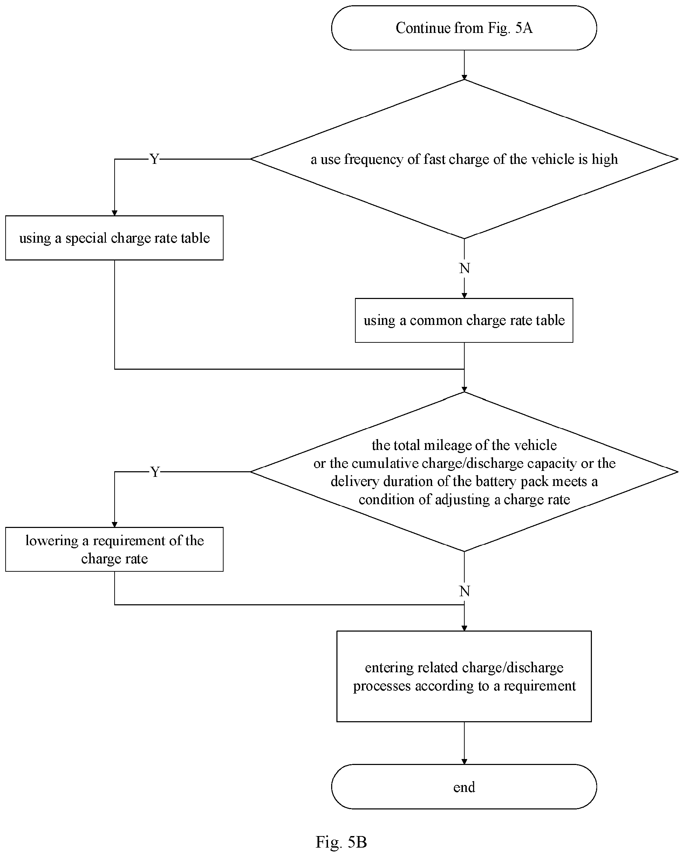

The embodiment of the present application is exemplarily illustrated below with reference to Figs. 5A and 5B:

Step 1: obtaining a direct current charge cumulative capacity $C_{dchg}$, an alternating current charge cumulative capacity $C_{achg}$ and a cumulative discharge capacity $C_d$ respectively by means of a current and time integration method; and acquiring delivery duration T of a battery pack and a total mileage M of a vehicle.

Step 2: determining whether the total mileage of the vehicle or a cumulative charge/discharge capacity or the delivery duration of the battery pack meets a condition of adjusting a lower limit state of charge (SOC), if so, increasing a requirement of the lower discharge limit SOC, and otherwise, keeping the lower discharge limit SOC unchanged. Specifically, the total traveling mileage M is sequentially compared with a plurality of traveling mileage thresholds $M_{SOCDL1}$, $M_{SOCDL2}$ ⋯ ⋯ $M_{SOCDLn}$($M_{SOCDL1} < M_{SOCDL2} < \cdots < M_{SOCDLn}$), and a first lower limit state of charge $SOC_{d1}$ corresponding to M is obtained according to a correlation between each traveling mileage threshold or mileage aging level and the lower limit state of charge; the cumulative discharge capacity $C_d$ is sequentially compared with a plurality of discharge capacity thresholds $C_{SOCDL1}$, $C_{SOCDL2}$ ⋯ ⋯ $C_{SOCDLn}$($C_{SOCDL1} < C_{SOCDL2} < \cdots < C_{SOCDLn}$), and a second lower limit state of charge $SOC_{d2}$ corresponding to Cd is obtained according to a correlation between each discharge capacity threshold or capacity aging level and the lower limit state of charge; by the same reasoning, use duration T may be compared with a plurality of use duration thresholds $T_{SOCDL1}$, $T_{SOCDL2}$ ⋯ ⋯ $T_{SOCDLn}$ ($T_{SOCDL1} < T_{SOCDL2} < \cdots < T_{SOCDLn}$), and a third lower limit state of charge $SOC_{d3}$ corresponding to T is obtained according to a correlation between each use duration threshold or use duration aging level and the lower limit state of charge; and finally, a maximum value among the first lower limit state of charge $SOC_{d1}$, the second lower limit state of charge $SOC_{d2}$ and the third lower limit state of charge $SOC_{d3}$ is selected as a target lower limit state of charge $SOC_d$ of the whole vehicle, i.e., a protection value of the lowest discharge SOC of the current vehicle is set to be $SOC_d$. If the total traveling mileage M is less than $M_{SOCDL1}$, the use duration T is less than $T_{SOCDL1}$, and the cumulative discharge capacity $C_d$ is less than $C_{SOCDL1}$, the lowest discharge SOC of the current vehicle may be kept unchanged. The protection value of the lower limit state of charge $SOC_d$ of the whole vehicle may become higher along with aging of the battery pack.

Step 3: determining whether the total mileage of the vehicle or the cumulative charge/discharge capacity or the delivery duration of the battery pack meets a condition of adjusting an upper limit SOC, if so, lowering a requirement of the upper limit SOC, and otherwise, keeping the upper limit SOC unchanged. Specifically, the total traveling mileage M is sequentially compared with the plurality of traveling mileage thresholds $M_{SOCUL1}$, $M_{SOCUL2}$ ⋯ ⋯ $M_{SOCULn}$($M_{SOCUL1} < M_{SOCUL2} < \cdots < M_{SOCULn}$), and a first upper limit state of charge $SOC_{u1}$ corresponding to M is obtained according to a correlation between each traveling mileage threshold or mileage aging level and the upper limit state of charge; the cumulative discharge capacity $C_d$ is sequentially compared with the plurality of discharge capacity thresholds $C_{SOCUL1}$, $C_{SOCUL2}$ ⋯ ⋯ $C_{SOCULn}$ ($C_{SOCUL1} < C_{SOCUL2} < \cdots < C_{SOCULn}$), and a second upper limit state of charge $SOC_{u2}$ corresponding to Cd is obtained according to a correlation between each discharge capacity threshold or capacity aging level and the upper limit state of charge; by the same reasoning, the use duration T may be compared with the plurality of use duration thresholds $T_{SOCUL1}$, $T_{SOCUL2}$ ⋯ ⋯ $T_{SOCULn}$ ($T_{SOCUL1} < T_{SOCUL2} < \cdots < T_{SOCULn}$), and a third upper limit state of charge $SOC_{u3}$ corresponding to T is obtained according to a correlation between each use duration threshold or use duration aging level and the upper limit state of charge; and finally, a minimum value among the first upper limit state of charge $SOC_{u1}$, the second upper limit state of charge $SOC_{u2}$ and the third upper limit state of charge $SOC_{u3}$ is selected as a target upper limit state of charge $SOC_u$ of the whole vehicle, i.e., a protection value of the highest charge SOC of the current vehicle is set to be $SOC_u$. If the total traveling mileage M is less than $M_{SOCUL1}$, the use duration T is less than $T_{SOCUL1}$, and the cumulative discharge capacity $C_d$ is less than $C_{SOCUL1}$, the highest charge SOC of the current vehicle may be kept unchanged. The protection value of the upper limit state of charge $SOC_u$ of the whole vehicle may become lower along with aging of the battery pack.

Step 4: determining whether the total mileage of the vehicle or the cumulative charge/discharge capacity or the delivery duration of the battery pack meets a condition of adjusting an upper charge limit cell voltage, if so, lowering a requirement of the upper charge limit cell voltage, and otherwise, keeping the upper charge limit cell voltage unchanged. Specifically, the total traveling mileage M may be sequentially compared with the plurality of traveling mileage thresholds $M_{VUL1}$, $M_{VUL2}$ ⋯ ⋯ $M_{VULn}$($M_{VUL1} < M_{VUL2} < \cdots < M_{VULn}$), and a first upper limit charge voltage $V_{u1}$ is determined according to a correlation between each traveling mileage threshold or mileage aging level and the upper limit charge voltage; the use duration T may be compared with the plurality of use duration thresholds $T_{VUL1}$, $T_{VUL2}$ ⋯ ⋯ $T_{VULn}$($T_{VUL1} < T_{VUL2} < \cdots < T_{VULn}$), and a second upper limit charge voltage $V_{u2}$ is determined according to a correlation between each use duration threshold or use duration aging level and the upper limit charge voltage; the cumulative discharge capacity $C_d$ may be sequentially compared with the plurality of discharge capacity thresholds $C_{VUL1}$, $C_{VUL2}$ ... ... $C_{VULn}$($C_{VUL1}$ < $C_{VUL2}$ < $\cdots$ < $C_{VULn}$), and a third upper limit charge voltage $V_{u3}$ is determined according to a correlation between each discharge capacity threshold or capacity aging level and the upper limit charge voltage; and finally, a minimum value among the first upper limit charge voltage $V_{u1}$, the second upper limit charge voltage $V_{u2}$ and the third upper limit charge voltage $V_{u3}$ is selected as a target upper limit charge voltage $V_u$ of the whole vehicle, i.e., a protection value of the highest charge voltage V of the current vehicle is set to be $V_u$. If the total traveling mileage M is less than $M_{VUL1}$, the use duration T is less than $T_{VUL1}$, and the cumulative discharge capacity $C_d$ is less than $C_{VUL1}$, the highest charge cell voltage of the current vehicle is kept unchanged.

Step 5: determining whether a use frequency of fast charging of the vehicle is higher, if so, using a special charge rate for charge, and otherwise, using a common charge rate for charge. Specifically, a ratio Y of the direct current charge cumulative capacity $C_{dchg}$ to the total charge cumulative capacity $C_{dchg}$ + $C_{achg}$ is calculated to acquire a fast charging frequency,

$$Y = \left. C_{dchg} \middle/ (C_{dchg} + C_{achg}) \right.$$

that is, , $Y \leq 1$, and as Y approaches 1, it is indicative of a higher frequency of using direct-current (high-current) charge by the vehicle. If $Y \geq Yn$, it is determined that the frequency of using high-current charging by the vehicle is high, and a special initial charge rate such as a first charge rate is used for charge; otherwise, charging is carried out according to a common initial charge rate such as a second charge rate.

Step 6: determining whether the total mileage of the vehicle or the cumulative charge/discharge capacity or the delivery duration of the battery pack meets a condition of adjusting a charge rate, if so, lowering a requirement of the charge rate, and otherwise, keeping the charge rate unchanged. Specifically, the total traveling mileage M may be sequentially compared with the plurality of traveling mileage thresholds $M_{PL1}$, $M_{PL2}$ ... ... $M_{PLn}$($M_{PL1}$ < $M_{PL2}$ < $\cdots$ < $M_{PLn}$), and a first rate adjustment coefficient $A_{p1}$ is determined according to a correlation between each traveling mileage threshold or mileage aging level and a rate adjustment coefficient; the use duration T may be compared with the plurality of use duration thresholds $T_{PL1}$, $T_{PL2}$ ... ... $T_{PLn}$($T_{PL1}$ < $T_{PL2}$ < $\cdots$ < $T_{PLn}$), and a second rate adjustment coefficient $A_{p2}$ is determined according to a correlation between each use duration threshold or use duration aging level and the rate adjustment coefficient; the cumulative discharge capacity $C_d$ may be sequentially compared with the plurality of discharge capacity thresholds $C_{PL1}$, $C_{PL2}$ ... ... $C_{PLn}$($C_{PL1}$ < $C_{PL2}$ < $\cdots$ < $C_{PLn}$), and a third rate adjustment coefficient $A_{p3}$ is determined according to a correlation between each discharge capacity threshold or capacity aging level and the rate adjustment coefficient; a minimum value among the first rate adjustment coefficient $A_{p1}$, the second rate adjustment coefficient $A_{p2}$ and the third rate adjustment coefficient $A_{p3}$ may be selected as a target rate adjustment coefficient; and the product of the target rate adjustment coefficient and the initial charge rate is determined as a target charge rate, that is, a maximum charge rate allowed for the current vehicle. If the total traveling mileage M is less than $M_{PL1}$, the use duration T is less than $T_{PL1}$, and the cumulative discharge capacity $C_d$ is less than $C_{PL1}$, the rate adjustment coefficient may be set to be 1.

Step 7: the vehicle traveling or charging normally according to the determined target charge/discharge parameters after the above parameters are all determined.

According to the embodiment, the aging degree of the battery is measured from multiple dimensions, and meanwhile, the aging degree of the battery may be evaluated more comprehensively and is more accurate by counting the use habits of user charge, etc. as use environment factors of the battery. In addition, after the aging degree of the battery pack is determined, charge/discharge depths, charge current, etc. of the battery are adjusted according to the aging degree, thereby improving use safety of the aged battery from multiple dimensions.

It should be noted that method embodiments are expressed as combinations of a series of actions for simplicity of description, but it should be understood by those skilled in the art that the present application is not limited by the order of the actions described as some steps may be performed in other orders or concurrently in accordance with the embodiments of the present application. It should also be understood by those skilled in the art that the embodiments described in the description all belong to the preferred embodiments, and the actions involved are not necessarily required by the present application.

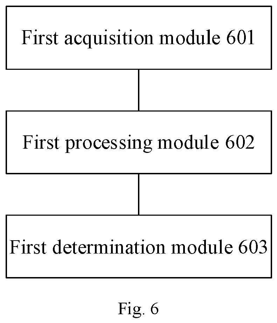

With reference to Fig. 6, a structural block diagram of one embodiment of a device for managing a battery of the present application is shown. The device may specifically include the following modules:

a first acquisition module 601 configured to acquire battery state parameters of an electric vehicle;
a first processing module 602 configured to compare the battery state parameters with a plurality of aging parameter thresholds respectively to determine a target aging level of the battery, the aging parameter thresholds corresponding to different aging levels of the battery; and

a first determination module 603 configured to determine target charge/discharge parameters corresponding to the target aging level according to pre-stored correlations between aging levels and charge/discharge parameters.

The battery state parameters include a total traveling mileage of the electric vehicle, and use duration and a cumulative discharge capacity of the battery; the plurality of aging parameter thresholds include a plurality of traveling mileage thresholds, a plurality of use duration thresholds and a plurality of discharge capacity thresholds,

the first processing module 602 is specifically configured to:

sequentially compare the total traveling mileage with the plurality of traveling mileage thresholds to determine a target mileage aging level; sequentially compare the use duration with the plurality of use duration thresholds to determine a target use duration aging level; and sequentially compare the cumulative discharge capacity with the plurality of discharge capacity thresholds to determine a target capacity aging level; and

the first determination module 603 is specifically configured to:
determine the target charge/discharge parameters corresponding to the target mileage aging level, the target use duration aging level and the target capacity aging level according to the pre-stored correlations between the aging levels and the charge/discharge parameters.

In one optional implementation, the charge/discharge parameters include lower limit discharge parameters, and the first determination module 603 is specifically configured to:

determine a first lower limit discharge parameter corresponding to the target mileage aging level according to pre-stored correlations between mileage aging levels and the lower limit discharge parameters; determine a second lower limit discharge parameter corresponding to the target use duration aging level according to pre-stored correlations between use duration aging levels and the lower limit discharge parameters; determine a third lower limit discharge parameter corresponding to the target capacity aging level according to pre-stored correlations between capacity aging levels and the lower limit discharge parameters; and
determine a maximum value among the first lower limit discharge parameter, the second lower limit discharge parameter and the third lower limit discharge parameter as a target lower limit discharge parameter.

In one optional implementation, the charge/discharge parameters include upper limit charge parameters, and the first determination module 603 is specifically configured to:

determine a first upper limit charge parameter corresponding to the target mileage aging level according to pre-stored correlations between the mileage aging levels and the upper limit charge parameters; and
determine a second upper limit charge parameter corresponding to the target use duration aging level according to pre-stored correlations between the use duration aging levels and the upper limit charge parameters;
determine a third upper limit charge parameter corresponding to the target capacity aging level according to pre-stored correlations between the capacity aging levels and the upper limit charge parameters; and
determine a minimum value among the first upper limit charge parameter, the second upper limit charge parameter and the third upper limit charge parameter as a target upper limit charge parameter.

The charge/discharge parameters include charge rates, the device further includes:

a second acquisition module, configured to acquire historical charge parameters;
a second processing module, configured to determine a fast charging frequency of the battery according to the historical charge parameters, the fast charging frequency being used for representing a frequency of high-current charging for the battery by a user;
a second determination module, configured to determine an initial charge rate of the battery according to the fast charging frequency; and
the first determination module 603 is specifically configured to:

determine a target rate adjustment coefficient corresponding to the target mileage aging level, the target use duration aging level and the target capacity aging level according to pre-stored correlations between the aging levels and rate adjustment coefficients; and
determine a product of the target rate adjustment coefficient and the initial charge rate as a target charge rate.

The first determination module 603 is specifically configured to:

> determine a first rate adjustment coefficient corresponding to the target mileage aging level according to pre-stored correlations between the mileage aging levels and the rate adjustment coefficients;
> determine a second rate adjustment coefficient corresponding to the target use duration aging level according to pre-stored correlations between the use duration aging levels and the rate adjustment coefficients;
> determine a third rate adjustment coefficient corresponding to the target capacity aging level according to pre-stored correlations between the capacity aging levels and the rate adjustment coefficients; and
> determine a minimum value among the first rate adjustment coefficient, the second rate adjustment coefficient and the third rate adjustment coefficient as the target rate adjustment coefficient.

The historical charge parameters include a direct current charge cumulative capacity and an alternating current charge cumulative capacity of the battery, and the first determination module 603 is specifically configured to:

> calculate a ratio of the direct current charge cumulative capacity to a total charge cumulative capacity, and determine the ratio as the fast charging frequency, the total charge cumulative capacity being the sum of the direct current charge cumulative capacity and the alternating current charge cumulative capacity;
> determine the initial charge rate of the battery as a first initial charge rate when the fast charging frequency is greater than or equal to a frequency threshold; and
> determine the initial charge rate of the battery as a second initial charge rate when the fast charging frequency is less than the frequency threshold, the first initial charge rate being less than the second initial charge rate.

Since the embodiment of the device is basically similar to the embodiment of the method, its description is relatively simple, and relevant contents may be seen from partial description of the embodiment of the method.

One embodiment of the present application further provides a vehicle. The vehicle includes a device according to the invention, a memory and a computer program that is stored on the memory and may run on the processor, where the computer program, when executed by the device, results in performance of the method for managing a battery of any one of the embodiments.

One embodiment of the present application further provides a computer readable storage medium. The computer readable storage medium stores a computer program, and the computer program, when executed by a device according to the invention, results in performance of the method for managing a battery.

Each embodiment of the description is described in a progressive manner, each embodiment focuses on the differences from other embodiments, and the same and similar parts between the embodiments may refer to each other.

Those skilled in the art should understand that the embodiments of the present application may be provided as a method, a device, or a computer program product. Therefore, the embodiments of the present application may take the form of hardware only embodiments, software only embodiments, or embodiments with a combination of software and hardware. Moreover, the embodiments of the present application may take the form of a computer program product that is implemented on one or more computer-usable storage media (including but not limited to a disk memory, a compact disc read only memory (CD-ROM), an optical memory, an electrically erasable programmable read-only memory (EEPROM), a Flash, an embedded multimedia card(eMMC), etc.) that include computer-usable program codes.

The embodiments of the present application are described with reference to the flow charts and/or block diagrams of the method, a terminal device (system), and the computer program product according to the embodiments of the present application. It should be understood that each flow and/or block in the flow charts and/or block diagrams and combinations of the flows and/or blocks in the flow charts and/or block diagrams may be implemented by computer program instructions. These computer program instructions may be provided for a general-purpose computer, a special-purpose computer, an embedded processor, or a processor of another programmable data processing terminal device to generate a machine, such that the instructions executed by a computer or a processor of another programmable data processing terminal device generate an apparatus for implementing a specific function in one or more processes in the flow charts and/or in one or more blocks in the block diagrams.

These computer program instructions may be stored in a computer readable memory that may instruct the computer or another programmable data processing terminal device to work in a specific manner, such that the instructions stored in the computer readable memory generate an artifact that includes an instruction apparatus. The instruction apparatus implements a specific function in one or more processes in the flowcharts and/or in one or more blocks in the block diagrams.

These computer program instructions may be loaded onto a computer or another programmable data processing terminal device, such that a series of operations and steps are executed on the computer or another programmable terminal device, thereby generating computer-implemented processing. Therefore, the instructions executed on the computer or another programmable terminal device provide steps for implementing a specific function in one or more processes in the flow charts and/or in one or more blocks in the block diagrams.

Finally, it should be noted that relational terms herein such as first and second are only used to distinguish one entity or operation from another entity or operation without necessarily requiring or implying any actual such relationship or order between such entities or operations. Moreover, terms "include", "contain", or any other variations thereof are intended to cover non-exclusive inclusions, such that a process, a method, an article, or a terminal device including a series of elements not only includes those elements, but also includes other elements that are not explicitly listed, or also includes inherent elements of the process, the method, the article, or the terminal device. Without more restrictions, the elements defined by the sentence "including a..." do not exclude the existence of other identical elements in the process, method, article, or terminal device including the elements.

The method for managing a battery and a device for managing a battery provided in the present application are introduced in detail above. Specific embodiments are used herein for illustration of the principles and implementations of the present application. The description of the above embodiments is merely used to help understand the method and its core concept of the present application. In addition, a common person skilled in the art may make modifications to the specific implementations and application in accordance with the concept of the present application.

## Claims

1. A method for managing a battery, comprising:

   acquiring (101, 201, 301, 401) battery state parameters of an electric vehicle, wherein the battery state parameters comprise a total traveling mileage of the electric vehicle, and use duration and a cumulative discharge capacity of the battery;
   comparing (102) the battery state parameters with a plurality of aging parameter thresholds respectively to determine a target aging level of the battery, the aging parameter thresholds corresponding to different aging levels of the battery, and wherein the plurality of aging parameter thresholds comprise a plurality of traveling mileage thresholds, a plurality of use duration thresholds and a plurality of discharge capacity thresholds; the method **characterized in that**:
   comparing the battery state parameters with a plurality of aging parameter thresholds respectively to determine a target aging level of the battery comprises:

   sequentially (202, 302, 402) comparing the total traveling mileage with the plurality of traveling mileage thresholds to determine a target mileage aging level,
   sequentially (203, 303, 403) comparing the use duration of the battery with the plurality of use duration thresholds to determine a target use duration aging level, and
   sequentially (204, 304, 404) comparing the cumulative discharge capacity with the plurality of discharge capacity thresholds to determine a target capacity aging level;

   the method being further **characterized by** further comprising

   acquiring (401) historical charge parameters, wherein the historical charge parameters comprise a direct current charge cumulative capacity and an alternating current charge cumulative capacity of the battery,
   determining (405) a fast charging frequency of the battery according to the historical charge parameters, the fast charging frequency being used for representing a frequency of high-current charging for the battery by a user, including calculating a ratio of the direct current charge cumulative capacity to a total charge cumulative capacity, and determining the ratio as the fast charging frequency, the total charge cumulative capacity being the sum of the direct current charge cumulative capacity and the alternating current charge cumulative capacity; and
   determining (406) an initial charge rate of the battery according to the fast charging frequency, including

   determining the initial charge rate of the battery as a first initial charge rate when the fast charging frequency is greater than or equal to a frequency threshold, and
   determining the initial charge rate of the battery as a second initial charge rate when the fast charging frequency is less than the frequency threshold, the first initial charge rate being less than the second initial charge rate; and
   determining (103) target charge/discharge parameters corresponding to the target aging level according to pre-stored correlations between aging levels and charge/discharge parameters, including determining (407) a target rate adjustment coefficient corresponding to the target mileage aging level, the target use duration aging level and the target capacity aging level according to the pre-stored correlations between the aging levels and rate adjustment coefficients, comprising

sequentially comparing the total travelling mileage to the plurality of travelling mileage thresholds and determining a first rate adjustment coefficient corresponding to the target mileage aging level according to pre-stored correlations between mileage aging levels and the rate adjustment coefficients;

comparing the use duration with the plurality of use duration thresholds and determining a second rate adjustment coefficient corresponding to the target use duration aging level according to pre-stored correlations between use duration aging levels and the rate adjustment coefficients;

sequentially comparing the cumulative discharge capacity with the plurality of discharge capacity thresholds and determining a third rate adjustment coefficient corresponding to the target capacity aging level according to pre-stored correlations between capacity aging levels and the rate adjustment coefficients; and

determining a minimum value among the first rate adjustment coefficient, the second rate adjustment coefficient and the third rate adjustment coefficient as the target rate adjustment coefficient, and

determining (408) a product of the target rate adjustment coefficient and the initial charge rate as a target charge rate.

2. The method for managing a battery according to claim 1, wherein the charge/discharge parameters comprise lower limit discharge parameters, and said determining the target charge/discharge parameters corresponding to the target mileage aging level, the target use duration aging level and the target capacity aging level according to the pre-stored correlations between the aging levels and the charge/discharge parameters comprises:

determining (205) a first lower limit discharge parameter corresponding to the target mileage aging level according to pre-stored correlations between mileage aging levels and the lower limit discharge parameters;

determining (206) a second lower limit discharge parameter corresponding to the target use duration aging level according to pre-stored correlations between use duration aging levels and the lower limit discharge parameters;

determining (207) a third lower limit discharge parameter corresponding to the target capacity aging level according to pre-stored correlations between capacity aging levels and the lower limit discharge parameters; and

determining (208) a maximum value among the first lower limit discharge parameter, the second lower limit discharge parameter and the third lower limit discharge parameter as a target lower limit discharge parameter.

3. The method for managing a battery according to claim 1, wherein the charge/discharge parameters comprise upper limit charge parameters, and said determining the target charge/discharge parameters corresponding to the target mileage aging level, the target use duration aging level and the target capacity aging level according to the pre-stored correlations between the aging levels and the charge/discharge parameters comprises:

determining (305) a first upper limit charge parameter corresponding to the target mileage aging level according to pre-stored correlations between mileage aging levels and the upper limit charge parameters;

determining (306) a second upper limit charge parameter corresponding to the target use duration aging level according to pre-stored correlations between use duration aging levels and the upper limit charge parameters;

determining (307) a third upper limit charge parameter corresponding to the target capacity aging level according to pre-stored correlations between capacity aging levels and the upper limit charge parameters; and

determining (308) a minimum value among the first upper limit charge parameter, the second upper limit charge parameter and the third upper limit charge parameter as a target upper limit charge parameter.

4. A device for managing a battery, comprising:

a first acquisition module (601), configured to acquire battery state parameters of an electric vehicle, wherein the battery state parameters comprise a total traveling mileage of the electric vehicle, and use duration and a cumulative discharge capacity of the battery,

a first processing module (602), configured to compare the battery state parameters with a plurality of aging parameter thresholds respectively to determine a target aging level of the battery, the aging parameter thresholds corresponding to different aging levels of the battery,

and wherein the plurality of aging parameter thresholds comprise a plurality of traveling mileage thresholds, a plurality of use duration thresholds and a plurality of discharge capacity thresholds;

**characterized in that**

the first processing module is specifically configured to:

sequentially compare the total traveling mileage with the plurality of traveling mileage thresholds to determine a target mileage aging level,

sequentially compare the use duration with the plurality of use duration thresholds to determine a target use duration aging level, and

sequentially compare the cumulative discharge capacity with the plurality of discharge capacity thresholds to determine a target capacity aging level;

a first determination module (603), configured to determine target charge/discharge parameters corresponding to the target aging level according to pre-stored correlations between aging levels and charge/discharge parameters, including being configured to determine (407) a target rate adjustment coefficient corresponding to the target mileage aging level, the target use duration aging level and the target capacity aging level according to the pre-stored correlations between the aging levels and rate adjustment coefficients, comprising being configured to

sequentially compare the total travelling mileage to the plurality of travelling mileage thresholds and determine a first rate adjustment coefficient corresponding to the target mileage aging level according to pre-stored correlations between mileage aging levels and the rate adjustment coefficients;

compare the use duration with the plurality of use duration thresholds and determine a second rate adjustment coefficient corresponding to the target use duration aging level according to pre-stored correlations between use duration aging levels and the rate adjustment coefficients;

sequentially compare the cumulative discharge capacity with the plurality of discharge capacity thresholds and determine a third rate adjustment coefficient corresponding to the target capacity aging level according to pre-stored correlations between capacity aging levels and the rate adjustment coefficients; and

determine a minimum value among the first rate adjustment coefficient, the second rate adjustment coefficient and the third rate adjustment coefficient as the target rate adjustment coefficient

the first determination module being further configured to determine a product of the target rate adjustment coefficient and an initial charge rate as a target charge rate;

a second acquisition module, configured to acquire historical charge parameters, wherein the historical charge parameters comprise a direct current charge cumulative capacity and an alternating current charge cumulative capacity of the battery;

a second processing module, configured to determine a fast charging frequency of the battery according to the historical charge parameters, the fast charging frequency being used for representing a frequency of high-current charging for the battery by a user, including being configured to calculate a ratio of the direct current charge cumulative capacity to a total charge cumulative capacity, and being configured to determine the ratio as the fast charging frequency, the total charge cumulative capacity being the sum of the direct current charge cumulative capacity and the alternating current charge cumulative capacity;

a second determination module, configured to determine the initial charge rate of the battery according to the fast charging frequency, including being configured to

determine the initial charge rate of the battery as a first initial charge rate when the fast charging frequency is greater than or equal to a frequency threshold, and

determine the initial charge rate of the battery as a second initial charge rate when the fast charging frequency is less than the frequency threshold, the first initial charge rate being less than the second initial charge rate.

5. The device for managing a battery according to claim 4, wherein the charge/discharge parameters comprise at least one of lower limit discharge parameters, upper limit charge parameters and charge rates.

6. A vehicle, comprising a device according to claim 4 and memory having a computer program stored thereon which, when executed by the device, results in performance of the method for managing a battery according to any one of claims 1-3.

7. A computer readable storage medium having a computer program stored thereon which, when executed by a device according to claim 4, results in performance of the method for managing a battery according to any one of claims 1-3.

**Patentansprüche**

1.  Batteriemanagementverfahren, das Folgendes beinhaltet:

    Erfassen (101, 201, 301, 401) von Batteriezustandsparametern eines Elektrofahrzeugs, wobei die Batteriezustandsparameter eine Gesamtlaufleistung des Elektrofahrzeugs und eine Nutzungsdauer und eine kumulative Entladekapazität der Batterie beinhalten;
    jeweiliges Vergleichen (102) der Batteriezustandsparameter mit einer Vielzahl von Alterungsparameterschwellenwerten zum Bestimmen eines Zielalterungsniveaus der Batterie, wobei die Alterungsparameterschwellenwerte verschiedenen Alterungsniveaus der Batterie entsprechen und wobei die Vielzahl von Alterungsparameterschwellenwerten eine Vielzahl von Laufleistungsschwellenwerten, eine Vielzahl von Nutzungsdauerschwellenwerten und eine Vielzahl von Entladekapazitätsschwellenwerten beinhaltet; wobei das Verfahren **dadurch gekennzeichnet ist, dass**: jeweiliges Vergleichen der Batteriezustandsparameter mit einer Vielzahl von Alterungsparameterschwellenwerten zum Bestimmen eines Zielalterungsniveaus der Batterie Folgendes beinhaltet:

        sequentielles (202, 302, 402) Vergleichen der Gesamtlaufleistung mit der Vielzahl von Laufleistungsschwellenwerten zum Bestimmen eines Zielfahrleistungsalterungsniveaus,
        sequentielles (203, 303, 403) Vergleichen der Nutzungsdauer der Batterie mit der Vielzahl von Nutzungsdauerschwellenwerten zum Bestimmen eines Zielnutzungsdaueralterungsniveaus, und
        sequentielles (204, 304, 404) Vergleichen der kumulativen Entladekapazität mit der Vielzahl von Entladekapazitätsschwellenwerten zum Bestimmen eines Zielkapazitätsalterungsniveaus;

    wobei das Verfahren ferner **dadurch gekennzeichnet ist, dass** es Folgendes beinhaltet:

        Erfassen (401) historischer Ladeparameter, wobei die historischen Ladeparameter eine kumulative Gleichstromladekapazität und eine kumulative Wechselstromladekapazität der Batterie beinhalten,
        Bestimmen (405) einer Schnellladehäufigkeit der Batterie gemäß den historischen Ladeparametern, wobei die Schnellladehäufigkeit zum Darstellen einer Hochstromladehäufigkeit für die Batterie durch einen Benutzer verwendet wird, umfassend das Berechnen eines Verhältnisses der kumulativen Gleichstromladekapazität zu einer kumulativen Gesamtladekapazität und Bestimmen des Verhältnisses als die Schnellladehäufigkeit, wobei die kumulative Gesamtladekapazität die Summe der kumulativen Gleichstromladekapazität und der kumulativen Wechselstromladekapazität ist; und
        Bestimmen (406) eines Anfangsladestroms der Batterie gemäß der Schnellladehäufigkeit, umfassend
        Bestimmen des Anfangsladestroms der Batterie als einen ersten Anfangsladestrom, wenn die Schnellladehäufigkeit größer oder gleich einem Häufigkeitsschwellenwert ist, und
        Bestimmen des Anfangsladestroms der Batterie als einen zweiten Anfangsladestrom, wenn die Schnellladehäufigkeit kleiner als der Häufigkeitsschwellenwert ist, wobei der erste Anfangsladestrom kleiner als der zweite Anfangsladestrom ist; und
        Bestimmen (103) von dem Zielalterungsniveau entsprechenden Ziellade-/-entladeparametern gemäß vorgespeicherten Korrelationen zwischen Alterungsniveaus und Lade-/Entladeparametern, umfassend Bestimmen (407) eines dem Zielfahrleistungsalterungsniveau, dem Zielnutzungsdaueralterungsniveau und dem Zielkapazitätsalterungsniveau entsprechenden Zielstromstärkeanpassungskoeffizienten gemäß den vorgespeicherten Korrelationen zwischen den Alterungsniveaus und den Stromstärkeanpassungskoeffizienten, beinhaltend

        sequentielles Vergleichen der Gesamtlaufleistung mit der Vielzahl von Laufleistungsschwellenwerten und Bestimmen eines dem Zielfahrleistungsalterungsniveau entsprechenden ersten Stromstärkeanpassungskoeffizienten gemäß vorgespeicherten Korrelationen zwischen Fahrleistungsalterungsniveaus und den Stromstärkeanpassungskoeffizienten;
        Vergleichen der Nutzungsdauer mit der Vielzahl von Nutzungsdauerschwellenwerten und Bestimmen eines dem Zielnutzungsdaueralterungsniveau entsprechenden zweiten Stromstärkeanpassungskoeffizienten gemäß vorgespeicherten Korrelationen zwischen Nutzungsdaueralterungsniveaus und den Stromstärkeanpassungskoeffizienten;

sequentielles Vergleichen der kumulativen Entladekapazität mit der Vielzahl von Entladekapazitätsschwellenwerten und Bestimmen eines dem Zielkapazitätsalterungsniveau entsprechenden dritten Stromstärkeanpassungskoeffizienten gemäß vorgespeicherten Korrelationen zwischen Kapazitätsalterungsniveaus und den Stromstärkeanpassungskoeffizienten; und

Bestimmen eines Mindestwerts unter dem ersten Stromstärkeanpassungskoeffizienten, dem zweiten Stromstärkeanpassungskoeffizienten und dem dritten Stromstärkeanpassungskoeffizienten als den Zielstromstärkeanpassungskoeffizienten, und

Bestimmen (408) eines Produkts des Zielstromstärkeanpassungskoeffizienten und des Anfangsladestroms als einen Zielladestrom.

2. Batteriemanagementverfahren nach Anspruch 1, wobei die Lade-/Entladeparameter Untergrenzenentladeparameter beinhalten und das genannte Bestimmen der dem Zielfahrleistungsalterungsniveau, dem Zielnutzungsdaueralterungsniveau und dem Zielkapazitätsalterungsniveau entsprechenden Ziellade-/-entladeparameter gemäß den vorgespeicherten Korrelationen zwischen den Alterungsniveaus und den Lade-/Entladeparametern Folgendes beinhaltet:

Bestimmen (205) eines dem Zielfahrleistungsalterungsniveau entsprechenden ersten Untergrenzenentladeparameters gemäß vorgespeicherten Korrelationen zwischen Fahrleistungsalterungsniveaus und den Untergrenzenentladeparametern;

Bestimmen (206) eines dem Zielnutzungsdaueralterungsniveau entsprechenden zweiten Untergrenzenentladeparameters gemäß vorgespeicherten Korrelationen zwischen Nutzungsdaueralterungsniveaus und den Untergrenzenentladeparametern;

Bestimmen (207) eines dem Zielkapazitätsalterungsniveau entsprechenden dritten Untergrenzenentladeparameters gemäß vorgespeicherten Korrelationen zwischen Kapazitätsalterungsniveaus und den Untergrenzenentladeparametern; und

Bestimmen (208) eines maximalen Werts unter dem ersten Untergrenzenentladeparameter, dem zweiten Untergrenzenentladeparameter und dem dritten Untergrenzenentladeparameter als einen Zieluntergrenzenentladeparameter.

3. Batteriemanagementverfahren nach Anspruch 1, wobei die Lade-/Entladeparameter Obergrenzenladeparameter beinhalten und das genannte Bestimmen der dem Zielfahrleistungsalterungsniveau, dem Zielnutzungsdaueralterungsniveau und dem Zielkapazitätsalterungsniveau entsprechenden Ziellade-/-entladeparameter gemäß vorgespeicherten Korrelationen zwischen den Alterungsniveaus und den Lade-/Entladeparametern Folgendes beinhaltet:

Bestimmen (305) eines dem Zielfahrleistungsalterungsniveau entsprechenden ersten Obergrenzenladeparameters gemäß vorgespeicherten Korrelationen zwischen Fahrleistungsalterungsniveaus und den Obergrenzenladeparametern;

Bestimmen (306) eines dem Zielnutzungsdaueralterungsniveau entsprechenden zweiten Obergrenzenladeparameters gemäß vorgespeicherten Korrelationen zwischen Nutzungsdaueralterungsniveaus und den Obergrenzenladeparametern;

Bestimmen (307) eines dem Zielkapazitätsalterungsniveau entsprechenden dritten Obergrenzenladeparameters gemäß vorgespeicherten Korrelationen zwischen Kapazitätsalterungsniveaus und den Obergrenzenladeparametern; und

Bestimmen (308) eines Mindestwerts unter dem ersten Obergrenzenladeparameter, dem zweiten Obergrenzenladeparameter und dem dritten Obergrenzenladeparameter als einen Zielobergrenzenladeparameter.

4. Batteriemanagementvorrichtung, die Folgendes beinhaltet:

ein erstes Erfassungsmodul (601), das zum Erfassen von Batteriezustandsparametern eines Elektrofahrzeugs konfiguriert ist, wobei die Batteriezustandsparameter eine Gesamtlaufleistung des Elektrofahrzeugs und eine Nutzungsdauer und eine kumulative Entladekapazität der Batterie beinhalten;

ein erstes Verarbeitungsmodul (602), das zum jeweiligen Vergleichen der Batteriezustandsparameter mit einer Vielzahl von Alterungsparameterschwellenwerten zum Bestimmen eines Zielalterungsniveaus der Batterie konfiguriert ist, wobei die Alterungsparameterschwellenwerte verschiedenen Alterungsniveaus der Batterie entsprechen und wobei die Vielzahl von Alterungsparameterschwellenwerten eine Vielzahl von Laufleistungsschwellenwerten, eine Vielzahl von Nutzungsdauerschwellenwerten und eine Vielzahl von Entladekapazitätsschwellenwerten beinhaltet;

**dadurch gekennzeichnet ist, dass**

das erste Verarbeitungsmodul speziell konfiguriert ist zum:

sequentiellen Vergleichen der Gesamtlaufleistung mit der Vielzahl von Laufleistungsschwellenwerten zum Bestimmen eines Zielfahrleistungsalterungsniveaus, sequentiellen Vergleichen der Nutzungsdauer mit der Vielzahl von Nutzungsdauerschwellenwerten zum Bestimmen eines Zielnutzungsdaueralterungsniveaus, und sequentiellen Vergleichen der kumulativen Entladekapazität mit der Vielzahl von Entladekapazitätsschwellenwerten zum Bestimmen eines Zielkapazitätsalterungsniveaus;

ein erstes Bestimmungsmodul (603), das zum Bestimmen von dem Zielalterungsniveau entsprechenden Ziellade-/-entladeparametern gemäß vorgespeicherten Korrelationen zwischen Alterungsniveaus und Lade-/Entladeparametern konfiguriert ist, umfassend, dass es zum Bestimmen (407) eines dem Zielfahrleistungsalterungsniveau, dem Zielnutzungsdaueralterungsniveau und dem Zielkapazitätsalterungsniveau entsprechenden Zielstromstärkeanpassungskoeffizienten gemäß den vorgespeicherten Korrelationen zwischen den Alterungsniveaus und den Stromstärkeanpassungskoeffizienten konfiguriert ist, beinhaltend, dass es konfiguriert ist zum

sequentiellen Vergleichen der Gesamtlaufleistung mit der Vielzahl von Laufleistungsschwellenwerten und Bestimmen eines dem Zielfahrleistungsalterungsniveau entsprechenden ersten Stromstärkeanpassungskoeffizienten gemäß vorgespeicherten Korrelationen zwischen Fahrleistungsalterungsniveaus und den Stromstärkeanpassungskoeffizienten; Vergleichen der Nutzungsdauer mit der Vielzahl von Nutzungsdauerschwellenwerten und Bestimmen eines dem Zielnutzungsdaueralterungsniveau entsprechenden zweiten Stromstärkeanpassungskoeffizienten gemäß vorgespeicherten Korrelationen zwischen Nutzungsdaueralterungsniveaus und den Stromstärkeanpassungskoeffizienten; sequentiellen Vergleichen der kumulativen Entladekapazität mit der Vielzahl von Entladekapazitätsschwellenwerten und Bestimmen eines dem Zielkapazitätsalterungsniveau entsprechenden dritten Stromstärkeanpassungskoeffizienten gemäß vorgespeicherten Korrelationen zwischen Kapazitätsalterungsniveaus und den Stromstärkeanpassungskoeffizienten; und Bestimmen eines Mindestwerts unter dem ersten Stromstärkeanpassungskoeffizienten, dem zweiten Stromstärkeanpassungskoeffizienten und dem dritten Stromstärkeanpassungskoeffizienten als den Zielstromstärkeanpassungskoeffizienten,

wobei das erste Bestimmungsmodul ferner konfiguriert ist zum Bestimmen eines Produkts des Zielstromstärkeanpassungskoeffizienten und eines Anfangsladestroms als einen Zielladestrom;
ein zweites Erfassungsmodul, das zum Erfassen historischer Ladeparameter konfiguriert ist, wobei die historischen Ladeparameter eine kumulative Gleichstromladekapazität und eine kumulative Wechselstromladekapazität der Batterie beinhalten,
ein zweites Verarbeitungsmodul, das zum Bestimmen einer Schnellladehäufigkeit der Batterie gemäß den historischen Ladeparametern konfiguriert ist, wobei die Schnellladehäufigkeit zum Darstellen einer Hochstromladehäufigkeit für die Batterie durch einen Benutzer verwendet wird, umfassend, dass es zum Berechnen eines Verhältnisses der kumulativen Gleichstromladekapazität zu einer kumulativen Gesamtladekapazität konfiguriert ist und zum Bestimmen des Verhältnisses als die Schnellladehäufigkeit konfiguriert ist, wobei die kumulative Gesamtladekapazität die Summe der kumulativen Gleichstromladekapazität und der kumulativen Wechselstromladekapazität ist;
ein zweites Bestimmungsmodul, das zum Bestimmen des Anfangsladestroms der Batterie gemäß der Schnellladehäufigkeit konfiguriert ist, umfassend, dass es konfiguriert ist zum Bestimmen des Anfangsladestroms der Batterie als einen ersten Anfangsladestrom, wenn die Schnellladehäufigkeit größer oder gleich einem Häufigkeitsschwellenwert ist, und Bestimmen des Anfangsladestroms der Batterie als einen zweiten Anfangsladestrom, wenn die Schnellladehäufigkeit kleiner als der Häufigkeitsschwellenwert ist, wobei der erste Anfangsladestrom kleiner als der zweite Anfangsladestrom ist.

5. Batteriemanagementvorrichtung nach Anspruch 4, wobei die Lade-/Entladeparameter mindestens eines von Untergrenzenentladeparametern, Obergrenzenladeparametern und Ladeströmen beinhalten.

6. Fahrzeug, das eine Vorrichtung nach Anspruch 4 und einen Speicher mit einem darin gespeicherten Computerprogramm beinhaltet, das bei Ausführung durch die Vorrichtung zur Durchführung des Batteriemanagementverfahrens nach einem der Ansprüche 1 bis 3 führt.

7. Computerlesbares Speichermedium mit einem darin gespeicherten Computerprogramm, das bei Ausführung durch eine Vorrichtung nach Anspruch 4 zur Durchführung des Batteriemanagementverfahrens nach einem der Ansprüche 1 bis 3 führt.

**Revendications**

1. Un procédé de gestion d'une batterie, comprenant :

l'acquisition (101, 201, 301, 401) de paramètres d'état de batterie d'un véhicule électrique, où les paramètres d'état de batterie comprennent un kilométrage de déplacement total du véhicule électrique, une durée d'utilisation et une capacité de décharge cumulative de la batterie, la comparaison (102) des paramètres d'état de batterie à une pluralité de seuils de paramètre de vieillissement respectivement de façon à déterminer un niveau de vieillissement cible de la batterie, les seuils de paramètre de vieillissement correspondant à des niveaux de vieillissement différents de la batterie, et où la pluralité de seuils de paramètre de vieillissement comprennent une pluralité de seuils de kilométrage de déplacement, une pluralité de seuils de durée d'utilisation et une pluralité de seuils de capacité de décharge, le procédé étant **caractérisé en ce que** :
la comparaison des paramètres d'état de batterie à une pluralité de seuils de paramètre de vieillissement respectivement de façon à déterminer un niveau de vieillissement cible de la batterie comprend :

la comparaison séquentielle (202, 302, 402) du kilométrage de déplacement total à la pluralité de seuils de kilométrage de déplacement de façon à déterminer un niveau de vieillissement de kilométrage cible, la comparaison séquentielle (203, 303, 403) de la durée d'utilisation de la batterie à la pluralité de seuils de durée d'utilisation de façon à déterminer un niveau de vieillissement de durée d'utilisation cible, et la comparaison séquentielle (204, 304, 404) de la capacité de décharge cumulative à la pluralité de seuils de capacité de décharge de façon à déterminer un niveau de vieillissement de capacité cible,

le procédé étant **caractérisé en outre en ce qu'**il comprend en outre :

l'acquisition (401) de paramètres de charge d'historique, où les paramètres de charge d'historique comprennent une capacité cumulative de charge en courant continu et une capacité cumulative de charge en courant alternatif de la batterie, la détermination (405) d'une fréquence de charge rapide de la batterie en fonction des paramètres de charge d'historique, la fréquence de charge rapide étant utilisée pour la représentation d'une fréquence de charge en courant de haute intensité pour la batterie par un utilisateur, comprenant le calcul d'un rapport de la capacité cumulative de charge en courant continu sur une capacité cumulative de charge totale, et la détermination du rapport en tant que fréquence de charge rapide, la capacité cumulative de charge totale étant la somme de la capacité cumulative de charge en courant continu et de la capacité cumulative de charge en courant alternatif, et la détermination (406) d'un taux de charge initial de la batterie en fonction de la fréquence de charge rapide, comprenant la détermination du taux de charge initial de la batterie en tant que premier taux de charge initial lorsque la fréquence de charge rapide est supérieure ou égale à une fréquence seuil, et la détermination du taux de charge initial de la batterie en tant que deuxième taux de charge initial lorsque la fréquence de charge rapide est inférieure à la fréquence seuil, le premier taux de charge initial étant inférieur au deuxième taux de charge initial, et la détermination (103) de paramètres de charge/décharge cibles correspondant au niveau de vieillissement cible en fonction de corrélations préconservées en mémoire entre des niveaux de vieillissement et des paramètres de charge/décharge, comprenant la détermination (407) d'un coefficient d'ajustement de taux cible correspondant au niveau de vieillissement de kilométrage cible, au niveau de vieillissement de durée d'utilisation cible et au niveau de vieillissement de capacité cible en fonction des corrélations préconservées en mémoire entre les niveaux de vieillissement et les coefficients d'ajustement de taux, comprenant la comparaison séquentielle du kilométrage de déplacement total à la pluralité de seuils de kilométrage de déplacement et la détermination d'un premier coefficient d'ajustement de taux correspondant au niveau de vieillissement de kilométrage cible en fonction de corrélations préconservées en mémoire entre des niveaux de vieillissement de kilométrage et les coefficients d'ajustement de taux,

la comparaison de la durée d'utilisation à la pluralité de seuils de durée d'utilisation et la détermination d'un deuxième coefficient d'ajustement de taux correspondant au niveau de vieillissement de durée d'utilisation cible en fonction de corrélations préconservées en mémoire entre des niveaux de vieillissement de durée d'utilisation et les coefficients d'ajustement de taux,

la comparaison séquentielle de la capacité de décharge cumulative à la pluralité de seuils de capacité de décharge et la détermination d'un troisième coefficient d'ajustement de taux correspondant au niveau de vieillissement de capacité cible en fonction de corrélations préconservées en mémoire entre des niveaux de vieillissement de capacité et les coefficients d'ajustement de taux, et

la détermination d'une valeur minimale parmi le premier coefficient d'ajustement de taux, le deuxième coefficient d'ajustement de taux et le troisième coefficient d'ajustement de taux en tant que coefficient d'ajustement de taux cible, et

la détermination (408) d'un produit du coefficient d'ajustement de taux cible et du taux de charge initial en tant que taux de charge cible.

2. Le procédé de gestion d'une batterie selon la Revendication 1, où les paramètres de charge/décharge comprennent des paramètres de décharge de limite inférieure, et ladite détermination des paramètres de charge/décharge cibles correspondant au niveau de vieillissement de kilométrage cible, au niveau de vieillissement de durée d'utilisation cible et au niveau de vieillissement de capacité cible en fonction des corrélations préconservées en mémoire entre les niveaux de vieillissement et les paramètres de charge/décharge comprend :

la détermination (205) d'un premier paramètre de décharge de limite inférieure correspondant au niveau de vieillissement de kilométrage cible en fonction de corrélations préconservées en mémoire entre des niveaux de vieillissement de kilométrage et les paramètres de décharge de limite inférieure,

la détermination (206) d'un deuxième paramètre de décharge de limite inférieure correspondant au niveau de vieillissement de durée d'utilisation cible en fonction de corrélations préconservées en mémoire entre des niveaux de vieillissement de durée d'utilisation et les paramètres de décharge de limite inférieure,

la détermination (207) d'un troisième paramètre de décharge de limite inférieure correspondant au niveau de vieillissement de capacité cible en fonction de corrélations préconservées en mémoire entre des niveaux de vieillissement de capacité et les paramètres de décharge de limite inférieure, et

la détermination (208) d'une valeur maximale parmi le premier paramètre de décharge de limite inférieure, le deuxième paramètre de décharge de limite inférieure et le troisième paramètre de décharge de limite inférieure en tant que paramètre de décharge de limite inférieure cible.

3. Le procédé de gestion d'une batterie selon la Revendication 1, où les paramètres de charge/décharge comprennent des paramètres de charge de limite supérieure, et ladite détermination des paramètres de charge/décharge cibles correspondant au niveau de vieillissement de kilométrage cible, au niveau de vieillissement de durée d'utilisation cible et au niveau de vieillissement de capacité cible en fonction des corrélations préconservées en mémoire entre les niveaux de vieillissement et les paramètres de charge/décharge comprend :

la détermination (305) d'un premier paramètre de charge de limite supérieure correspondant au niveau de vieillissement de kilométrage cible en fonction de corrélations préconservées en mémoire entre des niveaux de vieillissement de kilométrage et les paramètres de charge de limite supérieure,

la détermination (306) d'un deuxième paramètre de charge de limite supérieure correspondant au niveau de vieillissement de durée d'utilisation cible en fonction de corrélations préconservées en mémoire entre des niveaux de vieillissement de durée d'utilisation et les paramètres de charge de limite supérieure,

la détermination (307) d'un troisième paramètre de charge de limite supérieure correspondant au niveau de vieillissement de capacité cible en fonction de corrélations préconservées en mémoire entre des niveaux de vieillissement de capacité et les paramètres de charge de limite supérieure, et

la détermination (308) d'une valeur minimale parmi le premier paramètre de charge de limite supérieure, le deuxième paramètre de charge de limite supérieure et le troisième paramètre de charge de limite supérieure en tant que paramètre de charge de limite supérieure cible.

4. Un dispositif de gestion d'une batterie, comprenant :

un premier module d'acquisition (601), configuré de façon à acquérir des paramètres d'état de batterie d'un véhicule électrique, où les paramètres d'état de batterie comprennent un kilométrage de déplacement total du véhicule électrique, une durée d'utilisation et une capacité de décharge cumulative de la batterie,
un premier module de traitement (602), configuré de façon à comparer les paramètres d'état de batterie à une pluralité de seuils de paramètre de vieillissement respectivement de façon à déterminer un niveau de vieillissement cible de la batterie, les seuils de paramètre de vieillissement correspondant à des niveaux de vieillissement différents de la batterie, et où la pluralité de seuils de paramètre de vieillissement comprennent une pluralité de seuils de kilométrage de déplacement, une pluralité de seuils de durée d'utilisation et une pluralité de seuils de capacité de décharge

**caractérisé en ce que** le premier module de traitement est spécifiquement configuré de façon à :

comparer séquentiellement le kilométrage de déplacement total à la pluralité de seuils de kilométrage de déplacement de façon à déterminer un niveau de vieillissement de kilométrage cible,
comparer séquentiellement la durée d'utilisation à la pluralité de seuils de durée d'utilisation de façon à déterminer un niveau de vieillissement de durée d'utilisation cible, et comparer séquentiellement la capacité de décharge cumulative à la pluralité de seuils de capacité de décharge de façon à déterminer un niveau de vieillissement de capacité cible,
un premier module de détermination (603), configuré de façon à déterminer des paramètres de charge/décharge cibles correspondant au niveau de vieillissement cible en fonction de corrélations préconservées en mémoire entre des niveaux de vieillissement et des paramètres de charge/décharge, étant configuré également de façon à déterminer (407) un coefficient d'ajustement de taux cible correspondant au niveau de vieillissement de kilométrage cible, au niveau de vieillissement de durée d'utilisation cible et au niveau de vieillissement de capacité cible en fonction des corrélations préconservées en mémoire entre les niveaux de vieillissement et les coefficients d'ajustement de taux, étant configuré également de façon à
comparer séquentiellement le kilométrage de déplacement total à la pluralité de seuils de kilométrage de déplacement et déterminer un premier coefficient d'ajustement de taux correspondant au niveau de vieillissement de kilométrage cible en fonction de corrélations préconservées en mémoire entre des niveaux de vieillissement de kilométrage et les coefficients d'ajustement de taux,
comparer la durée d'utilisation à la pluralité de seuils de durée d'utilisation et déterminer un deuxième coefficient d'ajustement de taux correspondant au niveau de vieillissement de durée d'utilisation cible en fonction de corrélations préconservées en mémoire entre des niveaux de vieillissement de durée d'utilisation et les coefficients d'ajustement de taux,
comparer séquentiellement la capacité de décharge cumulative à la pluralité de seuils de capacité de décharge et déterminer un troisième coefficient d'ajustement de taux correspondant au niveau de vieillissement de capacité cible en fonction de corrélations préconservées en mémoire entre des niveaux de vieillissement de capacité et les coefficients d'ajustement de taux, et
déterminer une valeur minimale parmi le premier coefficient d'ajustement de taux, le deuxième coefficient d'ajustement de taux et le troisième coefficient d'ajustement de taux en tant que coefficient d'ajustement de taux cible,
le premier module de détermination étant configuré en outre de façon à déterminer un produit du coefficient d'ajustement de taux cible et un taux de charge initial en tant que taux de charge cible,
un deuxième module d'acquisition, configuré de façon à acquérir des paramètres de charge d'historique, où les paramètres de charge d'historique comprennent une capacité cumulative de charge en courant continu et une capacité cumulative de charge en courant alternatif de la batterie,
un deuxième module de traitement, configuré de façon à déterminer une fréquence de charge rapide de la batterie en fonction des paramètres de charge d'historique, la fréquence de charge rapide étant utilisée pour la représentation d'une fréquence de charge en courant de haute intensité pour la batterie par un utilisateur, étant configuré également de façon à calculer un rapport de la capacité cumulative de charge en courant continu sur une capacité cumulative de charge totale, et étant configuré de façon à déterminer le rapport en tant que fréquence de charge rapide, la capacité cumulative de charge totale étant la somme de la capacité cumulative de charge en courant continu et la capacité cumulative de charge en courant alternatif,
un deuxième module de détermination, configuré de façon à déterminer le taux de charge initial de la batterie en fonction de la fréquence de charge rapide, étant configuré également de façon à

déterminer le taux de charge initial de la batterie sous la forme d'un premier taux de charge initial lorsque la fréquence de charge rapide est supérieure ou égale à une fréquence seuil, et

déterminer le taux de charge initial de la batterie sous la forme d'un deuxième taux de charge initial lorsque la fréquence de charge rapide est inférieure à la fréquence seuil, le premier taux de charge initial étant inférieur au deuxième taux de charge initial.

5. Le dispositif de gestion d'une batterie selon la Revendication 4, où les paramètres de charge/décharge comprennent au moins un élément parmi des paramètres de décharge de limite inférieure, des paramètres de charge de limite supérieure et des taux de charge.

6. Un véhicule, comprenant un dispositif selon la Revendication 4 et une mémoire possédant un programme informatique conservé en mémoire sur celui-ci qui, lorsqu'il exécuté par le dispositif, résulte en l'exécution du procédé de gestion d'une batterie selon l'une quelconque des Revendications 1 à 3.

7. Un support à mémoire lisible par ordinateur possédant un programme informatique conservé en mémoire sur celui-ci qui, lorsqu'il est exécuté par un dispositif selon la Revendication 4, résulte en l'exécution du procédé de gestion d'une batterie selon l'une quelconque des Revendications 1 à 3.

acquiring battery state parameters of an electric vehicle — 101

comparing the battery state parameters with a plurality of aging parameter thresholds respectively to determine a target aging level of a battery, the aging parameter thresholds corresponding to different aging levels of the battery — 102

determining target charge/discharge parameters corresponding to the target aging level according to pre-stored correlations between the aging levels and charge/discharge parameters — 103

Fig. 1

acquiring battery state parameters of an electric vehicle, the battery state parameters including a total traveling mileage of the electric vehicle, and use duration and a cumulative discharge capacity of a battery — 201

sequentially comparing the total traveling mileage with a plurality of traveling mileage thresholds to determine a target mileage aging level — 202

sequentially comparing the use duration with a plurality of use duration thresholds to determine a target use duration aging level — 203

sequentially comparing the cumulative discharge capacity with a plurality of discharge capacity thresholds to determine a target capacity aging level — 204

determining a first lower limit discharge parameter corresponding to the target mileage aging level according to pre-stored correlations between mileage aging levels and the lower limit discharge parameters — 205

determining a second lower limit discharge parameter corresponding to the target use duration aging level according to pre-stored correlations between use duration aging levels and the lower limit discharge parameters — 206

determining a third lower limit discharge parameter corresponding to the target capacity aging level according to pre-stored correlations between capacity aging levels and the lower limit discharge parameters — 207

determining a maximum value among the first lower limit discharge parameter, the second lower limit discharge parameter and the third lower limit discharge parameter as a target lower limit discharge parameter — 208

Fig. 2

| acquiring battery state parameters of an electric vehicle, the battery state parameters including a total traveling mileage of the electric vehicle, and use duration and a cumulative discharge capacity of a battery | 301 |

| sequentially comparing the total traveling mileage with a plurality of traveling mileage thresholds to determine a target mileage aging level | 302 |

| sequentially comparing the use duration with a plurality of use duration thresholds to determine a target use duration aging level | 303 |

| sequentially comparing the cumulative discharge capacity with a plurality of discharge capacity thresholds to determine a target capacity aging level | 304 |

| determining a first upper limit charge parameter corresponding to the target mileage aging level according to pre-stored correlations between mileage aging levels and the upper limit charge parameters | 305 |

| determining a second upper limit charge parameter corresponding to the target use duration aging level according to pre-stored correlations between use duration aging levels and the upper limit charge parameters | 306 |

| determining a third upper limit charge parameter corresponding to the target capacity aging level according to pre-stored correlations between capacity aging levels and the upper limit charge parameters | 307 |

| determining a minimum value among the first upper limit charge parameter, the second upper limit charge parameter and the third upper limit charge parameter as a target upper limit charge parameter | 308 |

Fig. 3

acquiring battery state parameters and historical charge parameters, the battery state parameters including a total traveling mileage of an electric vehicle, and use duration and a cumulative discharge capacity of a battery ⟩~ 401

sequentially comparing the total traveling mileage with a plurality of traveling mileage thresholds to determine a target mileage aging level ⟩~ 402

sequentially comparing the use duration with a plurality of use duration thresholds to determine a target use duration aging level ⟩~ 403

sequentially comparing the cumulative discharge capacity with a plurality of discharge capacity thresholds to determine a target capacity aging level ⟩~ 404

determining a fast charging frequency of the battery according to the historical charge parameters, the fast charging frequency being used for representing a frequency of high-current charging for the battery by a user ⟩~ 405

determining an initial charge rate of the battery according to the fast charge frequency ⟩~ 406

determining a target rate adjustment coefficient corresponding to the target mileage aging level, the target duration aging level and the target capacity aging level according to pre-stored correlations between aging levels and rate adjustment coefficients ⟩~ 407

determining a product of the target rate adjustment coefficient and the initial charge rate as a target charge rate ⟩~ 408

Fig. 4

Fig. 5A

Fig. 5B

First acquisition module 601

First processing module 602

First determination module 603

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10222428 B2
- US 2017144563 A1
- US 2020353839 A1
- WO 2017133760 A